Europäisches Patentamt

European Patent Office

Office européen des brevets

(19)

(11) **EP 0 791 244 B1**

(12) **EUROPÄISCHE PATENTSCHRIFT**

(45) Veröffentlichungstag und Bekanntmachung des Hinweises auf die Patenterteilung:
**12.08.1998  Patentblatt 1998/33**

(21) Anmeldenummer: **95935917.5**

(22) Anmeldetag: **09.10.1995**

(51) Int Cl.⁶: **H03K 3/53**

(86) Internationale Anmeldenummer:
**PCT/EP95/03968**

(87) Internationale Veröffentlichungsnummer:
**WO 96/15589 (23.05.1996 Gazette 1996/23)**

(54) **MODULATOR ZUR ERZEUGUNG EINES ELEKTRISCHEN PULSES HOHER LEISTUNG**

MODULATOR FOR GENERATING A HIGH-POWER ELECTRIC PULSE

MODULATEUR POUR PRODUIRE UNE IMPULSION ELECTRIQUE DE PUISSANCE ELEVEE

(84) Benannte Vertragsstaaten:
**CH DE FR GB IT LI**

(30) Priorität: **09.11.1994  DE 4440013**

(43) Veröffentlichungstag der Anmeldung:
**27.08.1997  Patentblatt 1997/35**

(73) Patentinhaber: **Forschungszentrum Karlsruhe GmbH**
**76133 Karlsruhe (DE)**

(72) Erfinder:
• **SALBERT, Heinrich**
  **D-66793 Saarwellingen (DE)**
• **JÜNGST, Klaus-Peter**
  **D-76297 Stutensee (DE)**

(74) Vertreter: **Rückert, Friedrich, Dr. et al**
**Forschungszentrum Karlsruhe GmbH**
**Patente und Lizenzen**
**Weberstrasse 5**
**76133 Karlsruhe (DE)**

(56) Entgegenhaltungen:
EP-A- 0 196 960          FR-A- 2 538 942
US-A- 4 670 662

**Beschreibung**

Die Erfindung betrifft einen Modulator zur Erzeugung elektrischer Pulse hoher Leistung an einer Last.

Zur Erzeugung von solchen Hochleistungspulsen werden Energiespeicher benötigt, welche die für den Puls benötigte Energie zwischenspeichern und binnen kürzester Zeit an die Last abgeben können. Die Pulsdauer variiert je nach Anwendung von unter $10^{-9}$s in der Radartechnik bis zu $10^{-3}$s für Linearbeschleuniger. Während zur Erzeugung von Pulsen im Nano- und Mikrosekundenbereich pulsformende Netzwerke (PFN) genutzt werden, ist deren Anwendung im Millisekundenbereich wegen der großen zu speichernden Energie problematisch. Für die Erzeugung langer, leistungsstarker elektrischer Pulse, wie sie z. B. zur Klystronversorgung bei Linearbeschleunigern notwendig sind, werden Konzepte benötigt, die große Kapazitäten oder Induktivitäten als Energiespeicher benutzen.

Aus der DE-A-41 00 719 ist eine Schaltung zur stabilisierten Erzeugung von Hochspannungsimpulsen bekannt. Sie besteht aus einer Spannungsquelle, einem daran angeschlossenen Energiespeicher, der aus einem induktiven Energiespeicher in Reihe zu einem Leistungsschalter aufgebaut ist.

Weiter wird ein Impulsgenerator zur Impulserzeugung in Elektrozäunen in der DE-A-41 04 386 beschrieben. Ein Leistungsschalter wird von dem Lastzweig überbrückt. Der Lastzweig besteht aus der Hintereinanderschaltung der Last mit einem kapazitiven Energiespeicher.

Ein Modulator, der kapazitive Speicher benutzt, ist von den Fermi National Accelerator Laboratories entwickelt worden (siehe Konferenzbericht anläßlich des Twenty-First International Power Modulator Symposium, 1994; June 27 - 30, 1994, Westin South Coast, Plaza Hotel, Costa Mesa California; H.Pfeffer et al., 3.3: "A Long-Pulse Modulator for Reduced Size and Cost"). Dieser Modulator benutzt eine geschaltete Kondensatorbank mäßiger Größe, deren Spannung während des Pulses auf etwa 20 % der Anfangsspannung abfällt. Dieser große Abfall wird durch einen resonanten LC-Kreis ausgeglichen. Die Kondensatorbank ist an die hochliegende Seite des Primäreingangs eines Pulstransformators über eine Kaskade von Gate-Turn-Off-Thyristoren (GTO) angeschlossen. Der Resonanzkreis ist an die tiefliegende Klemme der Primärseite des Pulstransformators angeschlossen. Der Ausgangspuls ändert seinen Verlauf für die fast 2ms lange Dachzeit nur wenig. Der gemessene Wirkungsgrad vom Schalter zum Klystron und einschließlich der Energieverluste in der Anstiegszeit ist etwa 85 %.

In einem Konferenzbeitrag anläßlich des o. e. Power Modulator Symposium in Costa Mesa berichten H. Salbert et al. unter 3.4: "Generation of High-Power Pulses Using a SMES", daß zur Erzeugung von Hochleistungspulsen ein Leistungsmodulator für Linearbeschleuniger verwendet wird, der einen supraleitenden magnetischen Energiespeicher, SMES, besitzt. Mit diesem Leistungsmodulator sollen 2 ms dauernde Pulse von 3 kV und 300 A mit einer Repetitionsrate von 10 Hz erzeugt werden. Hierzu ist ein schneller Leistungsschalter, der aus IGBT's aufgebaut ist, und ein supraleitender magnetischer Energiespeicher in Entwicklung. Für eine ausreichende Stromtragfähigkeit und Spannungsfestigkeit besteht der Leistungsschalter aus in Reihe geschalteten Gruppen paralleler, gate-isolierter Bipolartransistoren (IGBT). Das Wirkungsprinzip eines solchen Pulsmodulators ist einfach und soll in seinen prinzipiellen Zügen kurz beschrieben werden:

Zunächst wird der aus dem Energiespeicher und dem geschlossenen Leistungsschalter bestehende Energiekreis von einer Spannungsquelle bis zu einem vorgesehenen Strom aufgeladen. Danach wird der Leistungsschalter geöffnet, so daß der Strom in den zum Leistungsschalter parallel liegenden Lastkreis kommutiert.

Ist die Last ein Klystron, so kann sie als ohmsch angenommen werden, und als Maschengleichung ergibt sich die zeitliche Abhängigkeit:

$$u(t) = U_{Quelle} + R^*I_{SMES}(0)^*e^{-R/L^*t},$$

wobei $U_{Quelle}$ die Spannung der Spannungsquelle ist, R der ohmsche Lastwiderstand und L die Induktivität des SMES. Es wird also im Klystron ein Leistungspuls erzeugt, dessen Amplitude proportional zum Quadrat des Strom durch den Energiespeicher ist.

Neben der Leistung des erzeugten Pulses ist der Spannungsabfall während der Pulsdauer eine wichtige Größe. Hierüber wird die notwendige Induktivität und damit der mögliche Energieinhalt des Energiespeichers ermittelt. Bei sehr flachen, wenig abfallenden Pulsdächern, d. h. sehr kurzen Pulsdauern gegenüber der Zeitkonstanten $\tau = L/R$, muß insbesondere die zu speichernde Energie ein Vielfaches der Pulsenergie betragen. (In o. e. Konferenzpapier ist etwa ein Verhältnis von 25 vorgesehen.) Diese Forderung bestimmt im wesentlichen die Kosten für einen solchen Modulator, da entsprechend dieser Forderung der Energiespeicher ausgelegt werden muß.

Hinzu kommt, daß der Spannungsabfall während der Pulsdauer durch die Wechselstromverluste des verwendeten Supraleiters im Energiespeicher begrenzt ist. Ein zu schnelles Entladen (großes di/dt) des Energiespeichers verursacht Wechselstromverluste im Supraleiter, die letztlich zum Quench (Übergang vom supraleitenden zum normalleitenden Zustand) führen können. Das kann zur Folge haben, daß ein erheblich teurerer Supraleitertyp eingesetzt werden muß, mit dem diese Einschränkung bei diesen Parametern noch nicht besteht.

Der Erfindung liegt die Aufgabe zugrunde, einen Pulsmodulator bereitzustellen, dessen Energiespeicherinduktivität wesentlich kleiner ist und das Verhältnis von gespeicherter Energie zur Pulsenergie erheblich reduziert ist.

Die Aufgabe wird erfindungsgemäß durch die kennzeichnenden Merkmale des Anspruchs 1 gelöst. Der oben aufgeführte Modulator mit dem einzigen Energiespeicher, nämlich dem induktiven Energiespeicher (SMES), ist dahingehend erweitert, daß im Lastzweig eine Serienschaltung aus einem Kondensator und einem zweiten Schalter hinzugefügt und der Kondensator über eine gesonderte Stromquelle aufgeladen wird. Wärend der Pulsdauer besteht somit ein Serienschwingkreis. Mit den beiden Schaltern, von denen immer der eine im andern Zustand ist wie der andere, läßt sich dies erreichen.

Der Vorteil des so aufgebauten Modulators liegt darin, daß nach dem Öffnen des Leistungsschalters und gleichzeitigem Schließen des zweiten Schalters, also nachdem der induktive Energiespeicher von dem vorgesehenen Strom durchflossen wird, und am kapazitiven Energiespeicher die vorgesehene Spannung anliegt, zwei Energiespeicher im Lastkreis liegen. Die Entladespannung am induktiven Energiespeicher, der Spule, kann somit über die Spannung am kapazitiven Energiespeicher, dem Kondensator, beliebig eingestellt werden. Sie kann auf deutlich kleinere Werte eingestellt werden und bewirkt so eine wesentlich geringere Entladung der Spule.

Hinzu kommt, daß das Pulsdach bei diesem Aufbau des Modulators nicht durch die Zeitkonstante L/R bestimmt, vielmehr ergibt es sich in seiner Form aus den Anfangsbedingungen, ab dem Zeitpunkt, ab dem der zweite Schalter leitet, und dem Umladeverhalten des während der Pulsdauer bestehenden L-R-C-Serienschwingkreises.

Der Modulator richtet sich in seiner Bauteiledimensionierung nach der zu betreibenden Last. Damit besteht nur noch die Freiheit die Induktivität des Energiespeichers und die Kapazität des Kondensators festzulegen. Durch geeignete Dimensionierung dieser beiden Bauteile und Wahl der Anfangsbedingungen (ab dem Moment, ab dem der Schalter leitend ist) kann die in dem Modulator gespeicherte Energie um etwa das Dreifache der Pulsenergie reduziert bleiben.

Das Verhältnis aus Pulspause zu Pulsdauer bestimmt die Höhe der Spannung an der Spannungsquelle. Daher kann die Quellenspannung klein sein, wenn das Verhältnis groß ist. Umgekehrt muß sie groß sein. Daß die Spannungsquelle gesteuert werden kann, ist daher zweckmäßig. Eine ungesteuerte Spannungsquelle wäre nur bei stets gleichbleibendem Puls-Pausen-Verhältnis und gleichbleibenden Anfangsbedingungen ausreichend. Damit geht einher, daß die im induktiven Energiespeicher gespeicherte Anfangsenergie auf etwa ein Zehntel der Anfangsenergie im induktiven Energiespeicher gegenüber dem o.e. Stand der Technik reduziert bleiben kann, und zwar ohne Einschränkung in der Pulsenergie. Bei einem solchen Modulator kann dann schließlich ein wesentlich billigerer Supraleiter verwendet werden, da ja zu schnelle zeitliche Stromänderungen unterbleiben. Das alles zusammen führt zu einen erheblich wirtschaftlicheren Aufbau des Modulators. Darüber hinaus wird mit dieser Schaltung eine wirksame Entlastung des Netzes erreicht, d.h. störende Rückwirkungen ins Netz vermieden werden, da die in der Last verbrauchte Energie während des Pulses alleine von dem kapazitiven und induktiven Energiespeicher entnommen wird, die beide in der Pulspause aufgeladen werden.

Die Erfindung soll anhand eines Durchführungsbeispiels und in Anlehnung an die Zeichnung weiters erläutert werden.

Es zeigen:

Figur 1 das Schaltungsprinzip des Pulsmodulators mit Strom- und Spannungsquelle und
Figur 2 die zeitlichen Verläufe der Lastspannung und der beiden Energiespeicherspannungen.

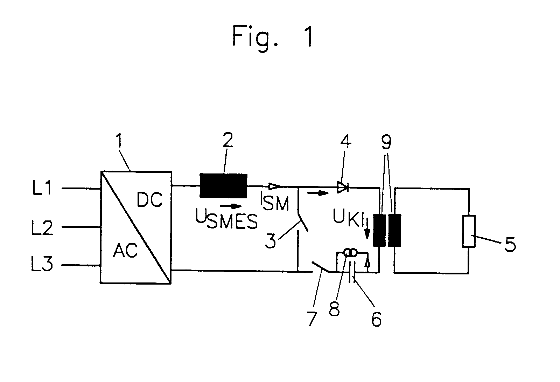

Die Gleichspannungsquelle 1 für den Pulsmodulator gemäß Figur 1 ist im Durchführungsbeispiel eine gesteuerte Drehstrombrücke. Der Leistungsschalter 3 ebenso wie der zweite Schalter 7 bestehen je aus hintereinander geschalteten Gruppen parallel geschalteter, gate-isolierter Bipolartransistoren (IGBT). Die Last 5 ist ein Klystron mit rein ohmschem Charakter. Bei Bedarf wird die Spannung für das Klystron über den Pulstransformator 9 hochtransformiert, wie das in der Figur 1 dargestellt ist. Die Hochstromdiode 4 im Lastkreis verhindert eine Stromumkehr. Die Stromquelle 8 zum Laden des Kondensators 6 ist ein steuerbares Netzgerät, mit dem die vorgesehene Spannung am Kondensator 6 aufgebaut werden kann. Geläufige Dinge wie Meßeinrichtungen, Schutzbeschaltungen und eine daran gekoppelte Steuerelektronik sind der Übersicht halber und wegen bekannter Technik nicht in die Figur 1 eingezeichnet.

Der Modulator ist, wie oben erwähnt, ein System mit zwei Energiespeichern 2, 6, nämlich dem induktiven Energiespeicher 2, hier dem supraleitenden magnetischen Energiespeicher (SMES), und dem kapazitiven Energiespeicher 6 im Lastzweig. Er soll im folgenden analytisch für die Pulsdauer näher betrachtet werden.

Die Aufladung des induktiven Energiespeichers 2 bis zum vorgesehenen Strom ist oben beschrieben. Gleichzeitig wird während dieses Ladungsvorgangs der Kondensator 6 im Lastzweig bis zu der vorgesehenen Spannung aufgeladen. Damit sind die vorgegebenen Anfangsbedingungen für den Pulsstrom und die Spannung am Kondensator 6 eingestellt und der Modulator kann betrieben werden. D.h. die beiden Schalter 2, 7 können synchron in ihre komplementären Zustände versetzt werden.

Ist der zweite Schalter 7 im leitenden Zustand, dann gilt unter Vernachlässigung der Quellenspannung an der Spannungsquelle 1 für die Spannung am Pulstransformator 9:

$$u_{KL}(t) = u_{SMES}(t) + u_c(t)$$

Die Vernachlässigung ist gerechtfertigt, da die eingangsseitige Spannung am Pulstransformator 9 etwa 3kV und die Spannung an der Spannungsquelle 1 nur 60V beträgt. Mit andern Worten, der Energiebeitrag der Spannungsquelle während der Pulsdauer ist vernachlässigbar. Die Entladespannung am SMES 2 kann nun über $U_C(0)$ frei eingestellt werden. Über die Beziehung

$$u(t) = -L*di/dt.$$

und ebenfalls über die Spannung $U_C(0)$ kann dB/dt frei eingestellt werden.

Während eines Pulses läßt sich der Strom im Laplace-Bereich nach folgender Beziehung berechnen:

$$I(s) = U(s)/(R+sL+1/sC) + 1/s*(I(0)*sL-U_C(0))/(R+sL+1/sC)$$

Unter Vernachlässigung des durch die Quellenspannung U(s) erzeugten Anteils hat der Strom nur einen, durch die Anfangsladungen des SMES 2 und Kondensators 6 verursachten transienten Anteil:

$$I(s) = 1/s*(I(0)*sL-U_C(0))/(R+sL+1/sC)$$

Nach der Rücktransformation in den Zeitbereich ergibt sich:

$$i(t) = I(0)*(e^{-at}\cos(bt) - a/b*e^{-at}\sin(bt))$$

$$- U_o/L*1/b*e^{-at}\sin(bt).$$

Dabei ist

$$a = R/2L$$

die Last durch die doppelte Energiespeicherinduktivität und

$$b^2 = 1/CL - a^2.$$

mit C als der Kondensatorkapazität.

Die Gleichung für i(t) beschreibt somit das transiente Entladen der Energiespeicher C und L.

Für den Einsatz als Pulsmodulator ist hier lediglich die Pulszeit < 2ms von Interesse. Während dieser Zeit kann sich ein beliebiges di/dt, auch ein di/dt>0, durch entsprechende Wahl der Anfangsbedingungen einstellen. Die Forderung nach einem Pulsdachabfall < 2% kann somit befriedigt werden.

Im Durchführungsbeispiel sind die Bauteile des Pulsmodulators wie folgt dimensioniert worden:

| | |
|---|---|
| das Klystron | $R = 8.9\Omega$ |
| Induktivität | $L = 0.1H$ |
| Strom | $I_{SMES} = 1\,125A$ |
| Kondensatorspannung | $U_C = 1\,100V$ |
| Kondensatorkapazität | $C = 0.44mF.$ |

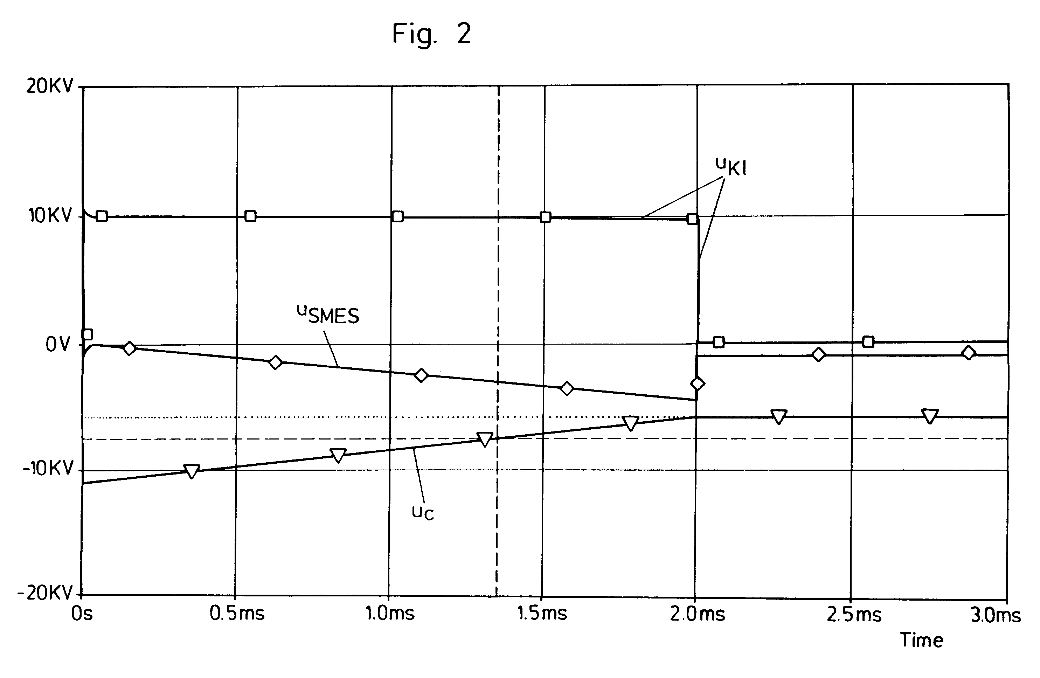

In der Figur 2 ist die Spannung $u_{kl}(t)$ an der Last, die Kondensatorspannung $u_c(t)$ und die Spannung an der Spule während der Pulszeit und zum Pulszeitende dargestellt.

Bezugszeichenliste

1 Spannungsquelle, Drehstrombrücke
2 Energiespeicher, Induktivität, Spule
3 Leistungsschalter
4 Stromventil, Diode
5 Last, Klystron
6 Energiespeicher,Kondensator
7 Schalter
8 Stromquelle, Netzgerät
9 Pulstransformator

**Patentansprüche**

1. Modulator zur Erzeugung eines elektrischen Pulses hoher Leistung an einer Last, bestehend aus

einer Spannungsquelle (1),
einem am Ausgang der Spannungsquelle (1) angeschlossenen Energiespeicherzweig, der aus einem induktiven Energiespeicher (2) in Reihe zu einem Leistungsschalter (3) aufgebaut ist,
einem den Leistungsschalter (3) überbrückenden Lastzweig, der aus einem Stromventil (4) in Reihe zu der elektrischen Last (5) aufgebaut ist,

dadurch gekennzeichnet, daß

sich im Lastzweig die Hintereinanderschaltung eines kapazitiven Energiespeichers (6) und eines zweiten Schalters (7) in Reihe zu der Last (5) befindet und der zweite Schalter (7) stets im komplementären Zustand zum Leistungsschalter (3) im Energiespeicherzweig ist,
sich parallel zum kapazitiven Energiespeicher (6) eine Stromquelle (8) befindet, die diesen mit vorgegebener Polarität und bis zu einer vorgebbaren Spannung auflädt, wodurch die Anfangsbedingungen für den elektrischen Puls festgelegt werden.

**Claims**

1. Modulator for generating a high-power electric pulse on a load, comprising

a voltage source (1),
an energy storage branch, which communicates with the output of the voltage source (1) and is built-up from an inductive energy store (2) in series with a power switch (3), and
a load branch, which bridges the power switch (3) and is built-up from a current rectifier (4) in series with the electrical load (5),

characterised in that

the series-connection of a capacitive energy store (6) and of a second switch (7) is situated in the load branch in series with the load (5), and the second switch (7) is always in the energy storage branch in the complementary state relative to the power switch (3), and
a current source (8) is situated parallel to the capacitive energy store (6), said source charging said store with a predetermined polarity and up to a predeterminable voltage, whereby the initial conditions for the electric pulse are set.

**Revendications**

1. Modulateur servant à produire une impulsion électrique de puissance élevée sur une charge, consistant en une source de tension (1), une branche d'accumulateur d'énergie raccordée à la sortie de la source de tension (1), branche qui est construite à partir d'un accumulateur d'énergie à induction (2) en série avec un interrupteur de puissance (3), une branche de charge en parallèle sur l'interrupteur de puissance (3), branche qui est construite à partir d'un régulateur d'intensité (4) en série avec la charge électrique (5), caractérisé en ce que

- dans la branche de la charge on a le montage l'un derrière l'autre d'un accumulateur d'énergie capacitif (6) et d'un deuxième interrupteur (7) en série avec la charge (5),
- le deuxième interrupteur (7) est en permanence dans un état complémentaire de celui de l'interrupteur de puissance (3) dans la branche de l'accumulateur d'énergie, et
- une source de courant (8) se trouve en parallèle sur l'accumulateur d'énergie capacitif (6), source de courant qui charge celui-ci avec une polarité prédéterminée et jusqu'à une tension que l'on peut prédéfinir, grâce à quoi les conditions initiales sont fixées pour l'impulsion électrique.

Fig. 1

Fig. 2

EP 0 791 244 B1